Europäisches Patentamt

European Patent Office

Office européen des brevets

(19)

(11)     **EP 1 118 004 B1**

(12)                       **FASCICULE DE BREVET EUROPEEN**

(45) Date de publication et mention
    de la délivrance du brevet:
    **07.04.2004  Bulletin 2004/15**

(51) Int Cl.[7]: **G01R 31/08**

(86) Numéro de dépôt international:
    **PCT/FR1999/002288**

(21) Numéro de dépôt: **99946236.9**

(22) Date de dépôt: **27.09.1999**

(87) Numéro de publication internationale:
    **WO 2000/019221 (06.04.2000 Gazette 2000/14)**

(54) **PROCEDE ET DISPOSITIF POUR LA LOCALISATION D'UN DEFAUT D'ISOLEMENT D'UN CABLE ELECTRIQUE**

**VERFAHREN UND VORRICHTUNG ZUR ERDSCHLUSSLOKALISIERUNG EINES ELEKTRISCHEN KABELS**

**METHOD AND DEVICE FOR LOCATING AN INSULATION FAULT IN AN ELECTRIC CABLE**

(84) Etats contractants désignés:
    **DE ES FR GB IT**

(30) Priorité: **28.09.1998  FR 9812420**

(43) Date de publication de la demande:
    **25.07.2001  Bulletin 2001/30**

(73) Titulaire: **SOCRAT**
    **F-83210 Sollies-Pont (FR)**

(72) Inventeur: **BUSSINGER, Jean**
    **83210 La Farlede (FR)**

(74) Mandataire: **Marchand, André**
    **OMNIPAT,**
    **24 Place des Martyrs de la Résistance**
    **13100 Aix-en-Provence (FR)**

(56) Documents cités:
    **EP-A- 0 327 191        US-A- 4 446 421**

    • **"FEHLERORTUNG IN KABELNETZEN" RADIO FERNSEHEN ELEKTRONIK, vol. 43, no. 11, 1 novembre 1994 (1994-11-01), page 44/45 XP000479734**
    • **BASCOM E C ET AL: "COMPUTERIZED UNDERGROUND CABLE FAULT LOCATION EXPERTISE" PROCEEDINGS OF THE POWER ENGINEERING SOCIETY TRANSMISSION AND DISTRIBUTION CONFERENCE, CHICAGO, APR. 10 - 15, 1994, 10 avril 1994 (1994-04-10), pages 376-382, XP000470557 INSTITUTE OF ELECTRICAL AND ELECTRONICS ENGINEERS**

**Description**

La présente invention concerne la localisation d'un défaut d'isolement d'un câble électrique.

La présente invention concerne plus particulièrement un procédé et un système de localisation d'un défaut d'isolement, relativement à la terre, de la gaine métallique d'un câble de télécommunication.

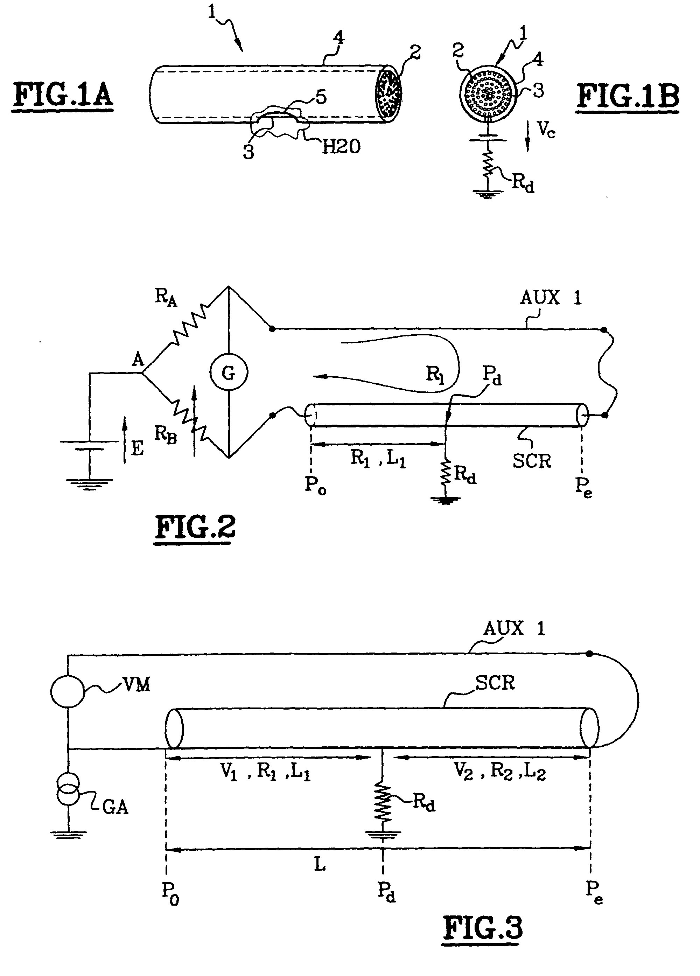

Les réseaux de télécommunication actuels, de structure arborescente, sont réalisés à partir de câbles 1 de forte section du type représenté en figure 1A, comprenant plusieurs centaines voire plusieurs milliers de fils électriques 2 isolés les uns des autres par un guipage approprié et agencés par deux pour former des "paires téléphoniques". L'ensemble est protégé contre les perturbations électriques par une gaine métallique, ou écran 3. L'écran 3 est lui-même recouvert par une gaine 4 protectrice en un matériau électriquement isolant comme du polyéthylène, du PVC,...

Ces câbles de télécommunications, agencés dans le sol, dans l'air, ou immergés, sont soumis à diverses agressions dont les plus fréquentes sont causées par la foudre, les rongeurs, les travaux de voirie, la chasse, le frottement des branches d'arbres... Comme on le voit en figure 1A, ces diverses agressions peuvent conduire à une déchirure 5 de la gaine protectrice et à une pénétration d'eau dans le câble. Du point de vue électrique, une telle dégradation se traduit par un défaut d'isolement de l'écran 3 vis-à-vis de la terre, schématisé en figure 1B par une résistance Rd, et conduit à l'apparition d'une tension Vc, ou "couple électrochimique", générée notamment par la combinaison du métal de l'écran 3 avec l'eau et divers oxydes métalliques. Lorsqu'un défaut d'étanchéité n'est pas réparé en temps utile, la dégradation du câble s'étend au guipage des fils électriques et se développe sur une grande longueur de câble en raison de la propagation de l'eau.

Le contrôle des câbles est ainsi une préoccupation majeure des opérateurs de télécommunication et nécessite de plus en plus d'être automatisé en vue d'une diminution des coûts de maintenance et des temps d'intervention sur site.

Les câbles de télécommunication présentant des longueurs non négligeables allant de la centaine de mètres à quelques kilomètres, la détection d'un défaut d'isolement doit être suivie d'une étape de localisation du défaut nécessaire à l'intervention d'un personnel qualifié.

On connaît diverses méthodes de localisation de défauts d'isolement entre conducteurs, dont certaines sont applicables à la détection d'un défaut d'isolement entre un conducteur et la terre. Parmi ces méthodes, les plus répandues sont les méthodes à pont de mesure et la méthode de la chute de tension.

La figure 2 illustre une méthode à pont de mesure classique. Le pont de mesure est formé par une résistance étalon RA, une résistance variable RB, et la résistance $R\ell$ d'une boucle comprenant un conducteur auxiliaire AUX1 et l'écran métallique SCR défectueux, l'écran étant relié à la terre en un point Pd par une résistance Rd représentant le défaut d'isolement à localiser. Le pont est alimenté par une tension continue E, généralement de l'ordre de 150 V, appliquée entre le point milieu A des résistances RA, RB et la terre, et comporte un galvanomètre G d'équilibrage. A l'équilibre du pont, la résistance électrique R1 que présente l'écran SCR entre son point d'origine Po et le point de défaut Pd est donnée par la relation :

$$(1) \qquad R1 = R\ell\ RB/(RA + RB)$$

Connaissant la résistance linéique de l'écran SCR, on en déduit la distance L1 séparant le point Pd du point d'origine Po.

Cette méthode de localisation, ainsi que d'autres méthodes similaires dérivées du pont de Wheatstone, présente divers inconvénients. D'une part, la méthode est basée sur une mesure de résistance et nécessite une conversion du résultat en une longueur, au moyen d'une valeur théorique de résistance linéique qui peut s'avérer inexacte. D'autre part, la précision de la mesure se dégrade lorsque la résistance Rd du défaut d'isolement devient élevée et doit être compensée par une augmentation sensible de la tension E d'alimentation du pont, pouvant ainsi atteindre les 500V. L'application d'une tension E aussi élevée peut entraîner un claquage des matériaux isolants du câble et représente un danger pour les matériels raccordés au réseau, nécessitant temporairement la mise hors service de celui-ci.

La méthode de la chute de tension, illustrée par la figure 3, consiste à injecter un courant $i$ dans l'écran métallique défectueux SCR au moyen d'un générateur de courant GA référencé à la terre. Le courant $i$ circule dans une boucle de terre formée par la résistance R1 de l'écran SCR entre le point d'origine Po et le point de défaut Pd, la résistance Rd du défaut, et la terre. La chute de tension V1 aux bornes de la résistance R1 est mesurée par un voltmètre VM connecté au point d'extrémité Pe de l'écran au moyen d'un fil auxiliaire AUX1. Une mesure similaire est faite à l'autre extrémité de l'écran, pour déterminer la chute de tension V2 aux bornes de la résistance R2 de l'écran entre le point de défaut Pd et le point d'extrémité Pe. La longueur L de l'écran étant connue, on en déduit la position relative Pdr du défaut :

$$(2) \qquad Pdr = L1/L = V1/(V1 + V2)$$

Cette méthode, comme la précédente, présente l'inconvénient de nécessiter une tension de mesure élevée lorsque la résistance Rd du défaut d'isolement est de forte valeur. Par exemple, l'injection d'un courant de 4mA nécessite l'application d'une tension de 4KV lorsque la résistance Rd est de l'ordre du Mégohm.

Par ailleurs, le document E.C. BASCOM ET AL "Computerized underground cable fault location expertise", présenté à la conférence "Proceedings of the power engineering society transmission and distribution conference, Chicago, April 10 -15, 1994", publié dans la revue IEEE du 10 avril 1994, pages 376-382, référence XP000470557, décrit en page 380 paragraphe 10) une méthode de localisation d'un défaut d'isolement entre un fil de phase et la masse, consistant à fait circuler un courant dans le fil de phase défectueux, en utilisant un fil de phase non défectueux connecté à une extrémité du fil de phase défectueux pour former une boucle de conduction, et à effectuer une mesure de tension aux deux extrémités du fil défectueux.

Un objectif de la présente invention est de prévoir un procédé de localisation d'un défaut d'isolement relativement à la terre de l'écran d'un câble électrique, qui ne nécessite pas une tension de mesure élevée tout en étant précis.

Un autre objéctif de la présente invention est de prévoir un procédé de localisation qui soit précis sur une large gamme de valeurs d'un défaut d'isolement, notamment jusqu'à des valeurs de l'ordre du Mégohm.

Encore un autre objectif de la présente invention est de prévoir un procédé de localisation qui soit simple à mettre en oeuvre et qui puisse s'intégrer dans un système de maintenance automatisé.

Ces objectifs, ainsi que d'autres, sont atteints par la prévision d'un procédé, selon la revendication 1, pour la localisation d'un défaut d'isolement d'un élément conducteur relativement à la terre, l'élément conducteur étant accessible électriquement au moins en un point d'origine et en un point d'extrémité, comprenant les étapes consistant à : injecter un courant entre le point d'origine et le point d'extrémité de l'élément conducteur, au moyen d'un générateur de courant ou de tension isolé de la terre ; mesurer une première tension électrique au point d'origine relativement à la terre ; mesurer une deuxième tension électrique au point d'extrémité, la première et la deuxième tensions mesurées étant liées par une relation représentative de la position relative du défaut d'isolement entre le point d'origine et le point d'extrémité.

En pratique, la deuxième tension peut être mesurée relativement au point d'origine ou relativement à la terre.

Selon un mode de réalisation, le générateur de courant ou de tension est agencé au point d'origine de l'élément conducteur et est connecté au point d'extrémité de l'élément conducteur au moyen d'un premier fil conducteur auxiliaire. Egalement, la deuxième tension peut être mesurée depuis le point d'origine de l'élément conducteur au moyen d'un second fil conducteur auxiliaire connecté au point d'extrémité de l'élément conducteur.

Selon un mode de réalisation, le courant injecté dans l'élément conducteur est un courant alternatif de très basse fréquence, de l'ordre du dixième de Hertz ou moins.

La présente invention concerne également un procédé de localisation du défaut d'isolement comprenant les étapes consistant à : déconnecter l'élément conducteur de la terre ; injecter dans l'élément conducteur un courant basse fréquence au moyen d'un générateur de courant ou de tension référencé à la terre, de manière à former une boucle de conduction passant par le défaut d'isolement et la terre ; détecter le courant circulant dans l'élément conducteur en déplaçant le long de l'élément conducteur un dispositif de détection de courant sans contact, jusqu'à détecter un point de variation du courant dans l'élément conducteur correspondant au défaut d'isolement recherché.

Avantageusement, le courant injecté dans l'élément conducteur comprend au moins deux courants de fréquences distinctes, et l'on compare les deux courants afin de déterminer la partie réelle des deux courants indépendante de capacités parasites réparties le long de l'élément conducteur.

Selon un mode de réalisation, l'élément conducteur comprend un écran métallique d'un câble de télécommunication ou plusieurs écrans métalliques de câbles de télécommunication raccordés entre eux.

La présente invention concerne également un dispositif de déconnexion relativement à la terre d'un écran métallique d'un câble de télécommunication, comprenant des moyens de communication avec un équipement de maintenance par l'intermédiaire d'une paire de fils téléphoniques, des moyens pour exécuter des commandes de connexion ou de déconnexion de l'écran relativement à la terre, et des moyens interrupteurs pour connecter l'écran à au moins un fil auxiliaire présent dans le câble de télécommunication.

Selon un mode de réalisation, le dispositif comprend des moyens pour déconnecter les moyens de communication de la paire de fils téléphoniques, et connecter l'écran à au moins un fil de la paire de fils téléphoniques, utilisé en tant que fil auxiliaire.

Selon un mode de réalisation, le dispositif comprend des moyens de mesure d'une tension électrique présente sur l'écran métallique.

Selon un mode de réalisation, le dispositif comprend des moyens pour injecter un courant dans l'écran métallique.

La présente invention concerne également un système de localisation automatique d'un défaut d'isolement, vis-à-vis de la terre, de l'écran métallique d'un câble comprenant des fils électriques, comprenant un générateur de courant ou de tension agencé en un point d'origine de l'écran, des moyens de mesure d'une tension électrique, des moyens pour connecter le générateur au point d'origine de l'écran et à un premier fil auxiliaire présent dans le câble, des moyens pour connecter les moyens de mesure au point d'origine de l'écran et à la terre, et des moyens pour connecter le fil auxiliaire à un point d'extrémité de l'écran.

Selon un mode de réalisation, les moyens pour connecter le premier fil auxiliaire à un point d'extrémité de l'écran comprennent un dispositif de déconnexion selon l'invention, du type décrit plus haut.

Selon un mode de réalisation, le système comprend des moyens pour connecter les moyens de mesure au point d'origine de l'écran et à un second fil auxiliaire présent dans le câble électrique, et des moyens pour connecter le second fil auxiliaire au point d'extrémité de l'écran.

Ces objectifs, caractéristiques et avantages ainsi que d'autres de la présente invention seront exposés plus en détail dans la description suivante du procédé de l'invention et d'exemples de dispositifs permettant de mettre en oeuvre le procédé, en relation avec les figures jointes parmi lesquelles :

- les figures 1A, 1B précédemment décrites représentent un câble de télécommunication présentant un défaut d'isolement,
- la figure 2 précédemment décrite illustre une méthode classique de localisation d'un défaut d'isolement,
- la figure 3 précédemment décrite illustre une autre méthode classique de localisation d'un défaut d'isolement,
- la figure 4 représente un système de localisation selon l'invention d'un défaut d'isolement, et illustre le procédé de l'invention,
- la figure 5 représente sous forme de blocs un dispositif de mesure intervenant dans le procédé de localisation selon l'invention,
- la figure 6 représente une variante de réalisation du système et du procédé de localisation de la figure 4,
- la figure 7 illustre une application du procédé de l'invention à la localisation d'un défaut d'isolement dans un réseau de câbles comprenant des écrans de différentes sections,
- la figure 8 représente un dispositif de déconnexion et de mesure selon l'invention, et
- la figure 9 illustre une variante du dispositif de déconnexion de la figure 8,
- la figure 10 représente un réseau de câbles de télécommunication équipé d'une pluralité de dispositifs selon la figure 9,
- la figure 11 illustre un second procédé selon l'invention de localisation d'un défaut d'isolement,
- la figure 12 représente des capacités réparties le long d'un câble, et
- la figure 13 illustre une application du second procédé à la localisation d'un défaut d'isolement dans un réseau de câbles arborescent.

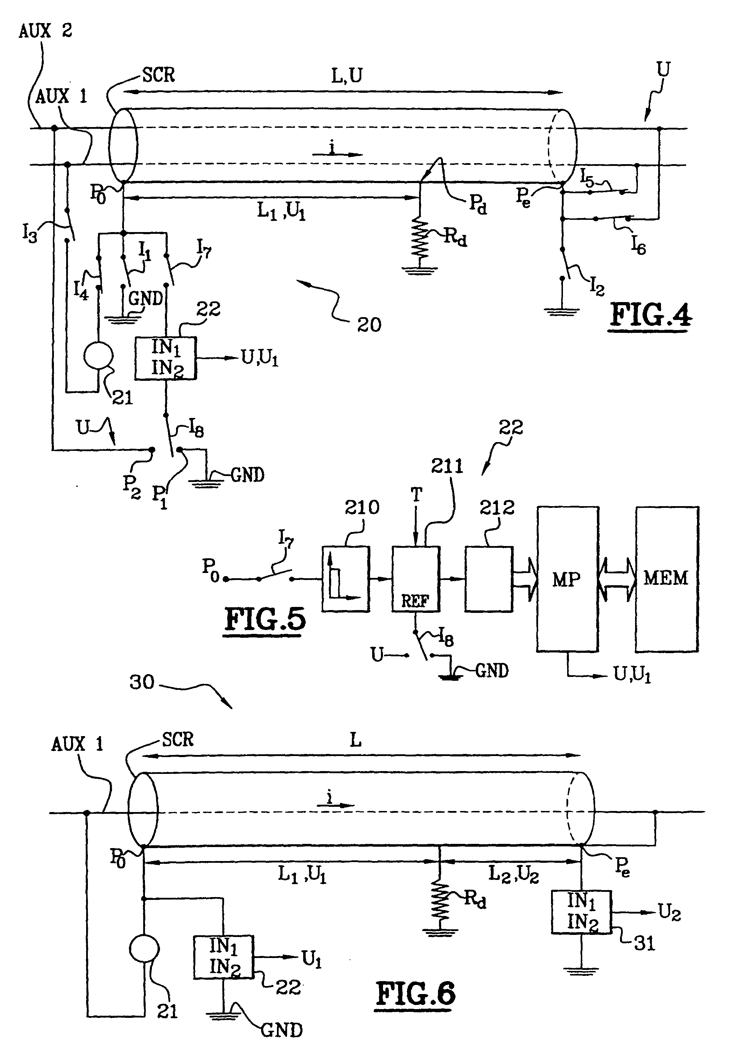

La figure 4 représente un système 20 selon l'invention, permettant de localiser un défaut d'isolement affectant l'écran métallique SCR d'un câble de télécommunication. Comme indiqué au préambule, le défaut d'isolement se traduit par une résistance Rd reliant l'écran à la terre en un point Pd devant être déterminé.

Le système de localisation 20 comprend deux fils auxiliaires AUX1, AUX2 choisis parmi un ensemble de fils téléphoniques présent à l'intérieur du câble (non représenté), un générateur 21 de courant ou de tension isolé de la terre GND, un dispositif 22 de mesure de tension à forte impédance d'entrée et divers interrupteurs I1 à I8. Le générateur 21 et le dispositif 22 sont agencés à proximité du point d'origine Po de l'écran. Les interrupteurs I1, I2 sont prévus pour déconnecter de la terre les points d'origine Po et d'extrémité Pe de l'écran SCR, et les interrupteurs I3 et I4 prévus pour connecter les sorties du générateur 21 au fil auxiliaire AUX1 et au point d'origine Po de l'écran. Les interrupteurs I5, 16 sont prévus pour connecter les fils auxiliaires AUX1, AUX2 au point d'extrémité Pe de l'écran, et l'interrupteur I7 prévu pour connecter une entrée IN1 du dispositif de mesure 22 au point d'origine Po de l'écran. Enfin, l'interrupteur 18 dans la position pl permet de connecter l'autre entrée IN2 du dispositif de mesure 22 à la terre et, dans la position p2, de connecter l'entrée IN2 au fil auxiliaire AUX2.

On va maintenant localiser le point de défaut Pd, situé entre le point d'origine Po et le point d'extrémité Pe, la longueur L de l'écran étant connue.

A cet effet, les interrupteurs I1, I2 sont ouverts, les interrupteurs I3 à I7 sont fermés et l'interrupteur I8 est placé sur la position pl. Le fil AUX1 et l'écran SCR forment une boucle de test connectée au générateur 21. Le fil AUX2 est connecté au point d'extrémité Pe de l'écran. Selon l'invention, on injecte dans la boucle de test un courant i et on mesure la tension U1 présente entre le point d'origine Po de l'écran et la terre. Le courant i étant maintenu, on bascule ensuite l'interrupteur I8 sur la position p2 et on mesure une tension U présente entre les points d'origine Po et d'extrémité Pe de l'écran. La mesure étant réalisée, le câble est replacé dans sa configuration initiale : les interrupteurs I3 à I7 sont ouverts et les interrupteurs I1, I2 sont fermés.

La tension U1 étant proportionnelle à la distance L1 entre le point Po et le point de défaut Pd, et la tension U proportionnelle à la distance entre le point Po et le point Pe, soit la longueur L de l'écran, on en déduit la position relative Pdr du défaut par rapport au point d'origine Po :

$$(3) \qquad Pdr = U1/U = L1/L$$

On en déduit la position absolue Pd du défaut, relativement au point d'origine Po :

$$(4) \qquad Pd = L1 = L\ U1/U$$

Comme cela apparaîtra clairement à l'homme de l'art, le procédé de l'invention ne nécessite pas l'application d'une tension élevée, la boucle de test étant isolée de la terre en tout point sauf au point de défaut Pd. Ainsi, le courant traversant le défaut Rd se limite à un courant de fuite très faible, suffisant pour la mesure des tensions U1, U et négligeable devant le courant *i*. La résistance électrique de l'écran et du fil auxiliaire AUX1 ne dépassant généralement pas quelques centaines d'ohm, une tension de travail de 1 à 5V seulement est suffisante pour obtenir un courant *i* dans la boucle de test de l'ordre de quelques dizaines de milliampère.

En pratique, une mesure des tensions U1, U en courant continu peut toutefois s'avérer entachée d'erreur en raison du phénomène classique de couple électrochimique.

Pour pallier cet inconvénient, chacune des tensions U1, U peut être mesurée en deux étapes au moyen de deux tensions continues de même valeur mais de signes opposés.

Selon une idée de la présente invention, une autre solution consiste à réaliser la mesure des tensions U1, U au moyen d'un courant i alternatif de très basse fréquence. La mesure en courant alternatif permet de s'affranchir du couple électrochimique et la prévision d'un courant très basse fréquence permet de s'affranchir de l'influence des capacités parasites réparties le long du câble.

La demanderesse a réalisé divers essais de caractérisation du procédé de l'invention avec un courant de mesure i alternatif, visant à vérifier le bien-fondé de cette idée. Le tableau 1 ci-après résume le résultat d'une première série d'essais'ayant pour but de déterminer, pour une large gamme de valeurs du défaut Rd allant de 0Ω (défaut franc) à 1 MΩ (défaut d'isolement provoqué par de l'humidité avant pénétration d'eau dans le câble), la fréquence de travail maximale Fmax au-delà de laquelle la précision du procédé se détériore et dépasse la valeur de 1% en localisation relative.

(Tableau 1)

| Valeur du défaut d'isolement et position relative sur l'écran | Fmax |
|---|---|
| Défaut franc positionné à 42% | 1000 Hz |
| Défaut franc positionné à 6% | 1000 Hz |
| Défaut de 1 MΩ positionné à 42% | 1 Hz |
| Défaut de 1 MΩ positionné à 6% | 100mHz |

Ces essais confirment l'avantage d'une mesure à très basse fréquence, en particulier pour la localisation d'un défaut Rd de forte valeur, et montrent que la fréquence de travail doit être de préférence inférieure à 100mHz, par exemple 5 ou 10 mHz.

Par ailleurs, le tableau 2 ci-après résume le résultat d'une deuxième série d'essais réalisés avec une fréquence de 10mHz, visant à déterminer l'influence de la position du défaut Rd sur la précision du procédé de localisation selon l'invention.

(Tableau 2)

| Position relative du défaut le long du câble | Valeur limite du défaut pour une localisation avec une précision d'au moins 1% |
|---|---|
| Pdr = 6% | 1,5 MΩ |
| Pdr = 42% | 10 MΩ |
| Pdr = 94% | 1 MΩ |

De façon générale, ces essais démontrent que le procédé selon l'invention permet de localiser avec une excellente précision des défauts d'isolement allant jusqu'à 1 MΩ, de sorte qu'il devient possible de localiser et réparer un défaut d'isolement naissant avant pénétration d'eau dans le câble. De plus, la mesure est faite au moyen d'une tension de faible valeur ne nécessitant pas la mise hors service du câble, l'opération étant ainsi transparente pour les abonnés.

D'autre part, les essais susmentionnés ont mis en évidence l'existence de bruits parasites large bande présents dans les basses fréquences, notamment dans la bande de travail préférentielle du procédé de l'invention allant de 5 à 100mHz. En pratique, ces bruits sont peu perceptibles dans le cas d'un défaut franc (0Ω) mais deviennent sensibles lorsque la résistance du défaut augmente et se rapproche du Mégohm. Ainsi, selon encore un autre aspect de l'invention, les tensions U, U1 sont mesurées au moyen d'un amplificateur à détection synchrone ou un système de traitement numérique du signal.

La figure 5 représente un exemple de réalisation du dispositif de mesure 22 permettant de s'affranchir des bruits large bande susmentionnés. Le dispositif 22 comprend en entrée un filtre passe-bas 210 ayant par exemple une fréquence de coupure de 1Hz, permettant de supprimer les bruits industriels de 50, 100 et 150 Hz. La sortie du filtre 210 est appliquée sur l'entrée d'un échantillonneur-bloqueur 211 dont l'entrée de référence de tension REF est connectée à l'interrupteur I8. La sortie de l'échantillonneur 211 est appliquée à un convertisseur analogique/numérique 212 dont la sortie est appliquée sur le port d'entrée d'un microprocesseur MP. Le microprocesseur MP est pourvu d'un algorithme classique de traitement du signal, stocké dans une mémoire programme MEM. Ainsi, le microprocesseur MP reconstitue un signal de mesure non bruité et délivre la valeur efficace ou la valeur crête des tensions U1 et U.

Une variante de réalisation dispositif 22 consiste à prévoir deux chaînes d'acquisition du signal agencées en parallèle, la première permettant de mesurer la tension U1 et la deuxième de mesurer la tension U. Dans ce cas, l'interrupteur I8 à deux positions est remplacé par deux interrupteurs simples, les tensions U1, U sont mesurées simultanément et le temps nécessaire aux deux mesures est divisé par deux. Ce temps est de l'ordre d'une période de la fréquence de travail, soit une centaine de secondes pour une fréquence de 10 mHz.

Bien entendu, le procédé selon l'invention est susceptible de diverses variantes et applications. Ainsi, la figure 6 représente une variante 30 du système de localisation selon l'invention dans laquelle le fil auxiliaire AUX2 n'est pas utilisé. Ici, un deuxième dispositif de mesure 31 est connecté entre le point d'extrémité Pe de l'écran SCR et la masse. Le dispositif 31 mesure une tension U2 entre le point Pe et la terre et le dispositif 22, connecté entre le point Po et la terre, mesure la tension U1 déjà décrite. Dans ce cas, la position relative Pdr du défaut d'isolement, par rapport au point d'origine Po, est donnée par la relation suivante, équivalente à la relation (4) décrite plus haut :

$$(5) \qquad Pdr = U1/(U1+U2)$$

ou par la relation :

$$(6) \qquad Pdr = 1/(1+(U2/U1)),$$

ou toute autre relation équivalente.

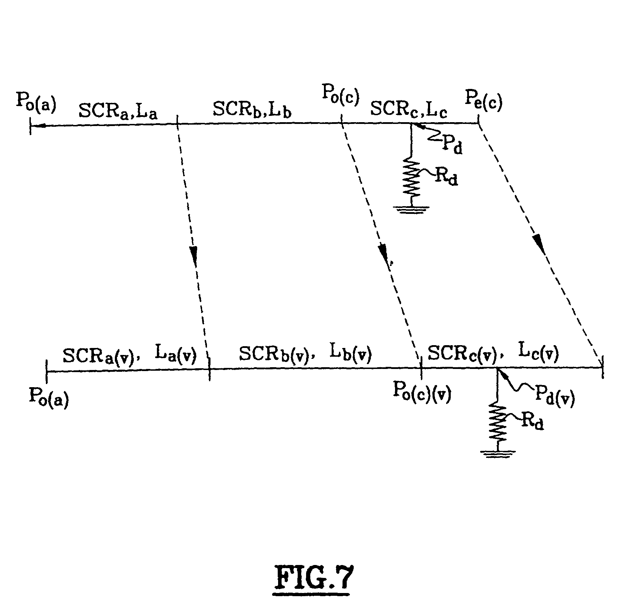

Par ailleurs, le procédé de l'invention est applicable à la localisation d'un défaut d'isolement dans un réseau de câbles comprenant plusieurs câbles de diamètres différents dont les écrans ne présentent pas la même résistivité linéique. A titre d'exemple, la figure 7 représente schématiquement un réseau comprenant trois câbles en série de longueurs respectives La, Lb, Lc, comportant des écrans SCRa, SCRb, SCRc de résistivités linéiques Ra, Rb, Rc. On suppose ici que les écrans sont en continuité électrique et ne sont accessibles électriquement qu'au point d'origine $Po_{(a)}$ de l'écran SCRa et au point d'extrémité $Pe_{(c)}$ de l'écran SCRc. Dans ces conditions, on considère que le réseau comprend trois écrans virtuels $SCRa_{(V)}$, $SCRb_{(V)}$, $SCRc_{(V)}$ de même résistance linéique, ayant des longueurs virtuelles $La_{(V)}$, $Lb_{(V)}$, $Lc_{(V)}$. La longueur virtuelle de chaque écran est calculée en multipliant sa longueur réelle par sa résistance linéique, le résultat pouvant être divisé par une constante, par exemple la résistance linéique Ra du premier écran SCRa :

$$(7) \qquad La_{(v)} = La \, Ra/Ra = La$$

$$(8) \qquad Lb_{(v)} = Lb \, Rb/Ra$$

$$(9) \qquad Lc_{(v)} = Lc \, Rc/Ra$$

Le procédé de l'invention est ensuite mis en oeuvre sur le réseau de la façon décrite plus haut, de sorte que l'on obtient une position virtuelle $Pd_{(a)(v)}$ du défaut d'isolement Rd relativement au point d'origine $Po_{(a)}$. On identifie

ensuite l'écran virtuel sur lequel se trouve le défaut, et l'on soustrait à la position virtuelle $Pd_{(a)(v)}$ les longueurs virtuelles des écrans précédents, par exemple les longueurs $La_{(v)}$, $Lb_{(v)}$ dans l'exemple de la figure 7. On obtient ainsi la position virtuelle $Pd_{(c)(v)}$ du défaut relativement au point d'origine $Po_{(c)(v)}$ du troisième écran virtuel $SCRc_{(v)}$. On en déduit la position réelle $Pd_{(c)}$ du défaut relativement au point d'origine $Po_{(c)}$ du troisième écran :

$$(10) \qquad Pd_{(c)} = Pd_{(c)(v)} \ Ra/Rc$$

En définitive, le procédé selon l'invention permet de localiser des défauts d'isolements de forte valeur avec une précision d'au moins 1%, sur des câbles de grande longueur, avec une tension de mesure alternative de faible valeur se trouvant en dehors de la bande téléphonique (300-3000 Hz). De plus, le procédé est d'une mise en oeuvre simple et rapide, l'interprétation des résultats obtenus est particulièrement aisée et ne nécessite pas l'emploi d'abaques ou de termes correctifs. De surcroît, le procédé n'est pas sensible aux résistances de contact parasites liées à la connexion des appareils de mesure. Enfin, le procédé peut être aisément intégré dans un système de maintenance automatisé, comme on le verra maintenant.

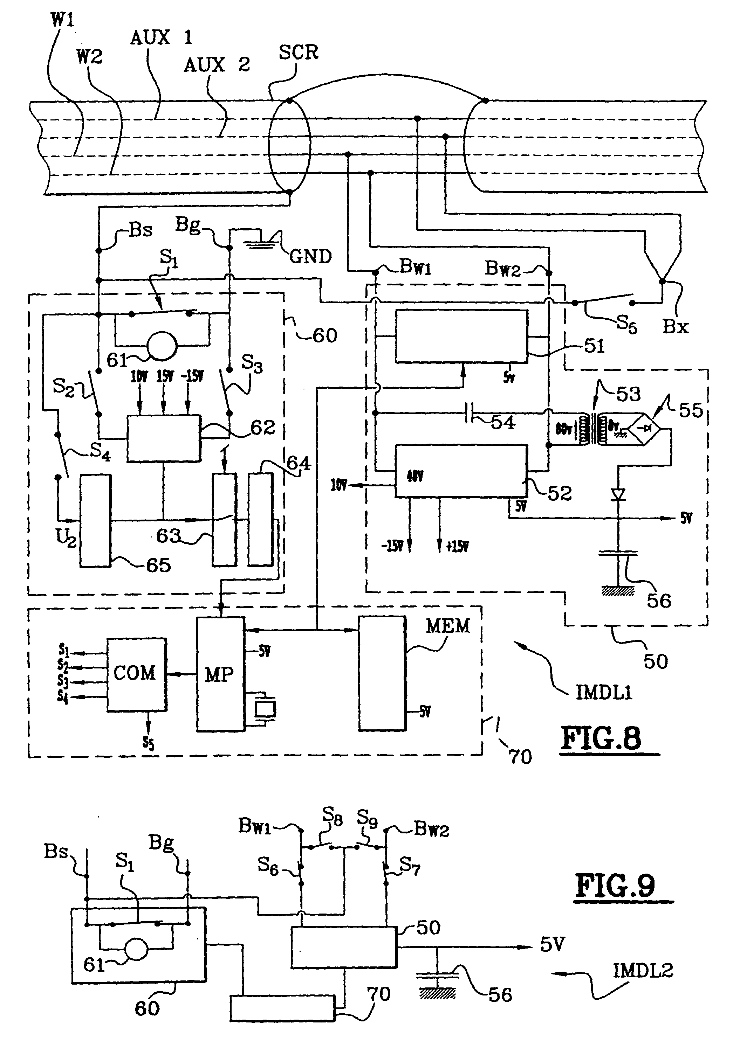

La figure 8 représente le schéma électrique d'un dispositif de déconnexion et de mesure IMDL1 selon l'invention, pouvant être commandé à distance. Le dispositif IMDL1, connecté à l'écran métallique SCR d'un câble de télécommunication ainsi qu'à une paire de fils téléphoniques W1, W2 et deux fils auxiliaires AUX1, AUX2 présents dans le câble, est prévu pour assurer plusieurs fonctions :

   i) la déconnexion de l'écran métallique SCR relativement à la terre GND,
   ii) la mesure de la résistance d'isolement et du couple électrochimique entre l'écran SCR et la terre GND,
   iii) la connexion des fils auxiliaires AUX1, AUX2 à l'écran SCR pour la mise en oeuvre du procédé de l'invention,

la fonction ii) étant indépendante de la fonction iii) et optionnelle au regard de la présente invention.

A cet effet, le dispositif IMDL1 comporte cinq bornes de connexion Bs, Bg, Bw1, Bw2, Bx, un circuit 50 de télécommunication et d'alimentation électrique, connecté aux bornes Bw1, Bw2, un circuit 60 de déconnexion et de mesure, connecté aux bornes Bs, Bg, et une unité centrale 70 connectée aux circuits 50, 60.

Le circuit 50 comprend un circuit 51 émetteur-récepteur DTMF ("Dual Tone Multi-Frequency") de type classique, un bloc d'alimentation 52 et un transformateur 53 80V/8V à fort courant de sortie connecté à l'une des bornes Bw1, Bw2 par l'intermédiaire d'une capacité 54. Le bloc d'alimentation 52 comporte divers régulateurs, délivre des tensions de 5V, $\pm$15V ainsi qu'une tension de référence de 10V. La sortie du transformateur 53 est appliquée à un circuit redresseur 55 dont la sortie charge une capacité 56 formant un réservoir d'énergie pour la tension d'alimentation de 5V.

L'unité centrale 70 comprend un microprocesseur MP pourvu d'une mémoire programme MEM, et un circuit COM de pilotage d'interrupteurs.

Le circuit 60 comprend un interrupteur S1 dans l'état normalement fermé en l'absence d'alimentation électrique, par exemple un relais, connecté entre les bornes Bs, Bg et protégé par un parasurtenseur 61. Le circuit 60 comprend également un circuit de mesure 62 connecté aux bornes Bs, Bg par l'intermédiaire d'interrupteurs S2, S3. La sortie du circuit 62 est appliquée à un circuit échantillonneur 63 suivi d'un convertisseur A/N 64 dont la sortie est envoyée au microprocesseur MP. Le circuit 62 comprend des moyens pour mesurer entre les bornes Bs, Bg une résistance d'isolement et/ou un couple électrochimique. Ces moyens, en soi classiques et dont le principe de fonctionnement est décrit dans le brevet EP 408 480, utilisent la tension de référence de 10V délivrée par le bloc 52 et une tension inversée de -10V délivrée par des amplificateurs opérationnels internes (non représentés) alimentés sous $\pm$15V.

Enfin, la borne Bx est reliée à la borne Bs par l'intermédiaire d'un interrupteur S5.

Lorsque le dispositif IMDL1 est en service, la borne Bs est connectée à l'écran métallique SCR, la borne Bg est connectée à la terre, les bornes Bw1, Bw2 sont connectées à la paire de fils téléphoniques W1, W2 et la borne Bx est connectée aux fils auxiliaires AUX1, AUX2. De façon classique, la paire de fils W1, W2 véhicule une tension continue d'alimentation de 48V et permet de transmettre des impulsions de sonnerie de 80V efficaces et des impulsions DTMF de quelques Volts.

On supposera maintenant que plusieurs dispositifs IMDL1 sont connectés en divers points du câble de télécommunication et sont tous reliés, par l'intermédiaire de la paire téléphonique W1, W2, à un équipement de maintenance agencé par exemple dans un central téléphonique. Lorsque des impulsions de sonnerie sont envoyées, la capacité d'isolement 54 devient passante, le transformateur 53 alimente le redresseur 55 qui charge rapidement la capacité 56. L'énergie électrique envoyée sur le réseau au moyen de la tension continue de 48V étant insuffisante pour alimenter simultanément plusieurs dispositifs IMDL1, la précharge de la capacité 56 pendant la sonnerie leur permet d'accumuler une énergie suffisante pour recevoir et analyser un code de sélection envoyé par l'équipement de maintenance sous forme d'impulsions codées DTMF. Ce code étant reçu, le dispositif IMDL1 sélectionné est alimenté par la tension de 48V sur la ligne et reste en attente d'une commande, reçue sous forme d'une suite d'impulsions DTMF. Les autres dispositifs IMDL1 se placent dans un état de sommeil où ils ne consomment presque plus d'énergie.

La commande reçue par le dispositif IMDL1 sélectionné peut être une commande d'ouverture de l'interrupteur S1 et de mesure de la résistance d'isolement ou d'un couple électrochimique, réalisée par le circuit 62. Le résultat de la mesure est numérisé et renvoyé par le microprocesseur à l'équipement de maintenance, sous forme codée DTMF.

Selon l'invention, le dispositif IMDL1 est également prévu pour exécuter une commande d'ouverture de l'interrupteur S1 et de fermeture de l'interrupteur S5. Dans ce cas, les fils AUX1, AUX2 se trouvent connectés à l'écran SCR. Le procédé de l'invention peut alors être mis en oeuvre depuis un point d'origine quelconque Po, en appliquant au point d'origine Po une tension basse fréquence et en procédant aux mesures des tensions U, U1 déjà décrites. Dans ce cas, les autres dispositifs IMDL1 connectés à l'écran SCR sont préalablement sélectionnés les uns après les autres pour recevoir une commande d'ouverture de l'interrupteur S1, afin de déconnecter tous les points de connexion volontaire de l'écran à la terre.

Selon une première variante de réalisation du dispositif IMDL1, le circuit de mesure 60 comprend un filtre passe-bas 65 connecté à la borne Bs par l'intermédiaire d'un interrupteur S4, et la sortie du filtre 65 est appliquée à l'entrée de l'échantillonneur 63. Un algorithme de traitement du signal est chargé dans la mémoire MEM du microprocesseur et le dispositif IMDL1 est agencé pour exécuter une commande de mesure de la tension U2 décrite plus haut en relation avec la figure 6. Dans ce cas, la tension U2 présente sur la borne Bs est filtrée par le filtre 65, échantillonnée et numérisée par les circuits 63, 64 puis analysée par le microprocesseur MP. Comme précédemment, le résultat de la mesure est envoyé à l'équipement de maintenance. Ici, le fil auxiliaire AUX2 permettant de mesurer la tension U depuis un point d'origine n'est pas nécessaire.

Selon une deuxième variante, le dispositif IMDL1 comprend le générateur basse fréquence 21 décrit plus haut et des moyens de mesure des tensions U1, U ou de la tension U1 seulement. Comme pour la première variante, ces moyens sont formés par la chaîne d'acquisition et de mesure comprenant le filtre 65, l'échantillonneur 63, le convertisseur 64 et le microprocesseur MP. Des interrupteurs dont l'agencement est à la portée de l'homme de l'art sont prévus pour assurer les diverses connexions du générateur 21 et de la chaîne de mesure à l'écran SCR, à la terre GND, aux fils auxiliaires AUX1, AUX2 ou au fil auxiliaire AUX1 seulement. On réalise ainsi un dispositif IMDL1$_{OR}$ du type "origine", permettant de définir un point d'origine Po d'injection du courant pour la mise en oeuvre du procédé de l'invention.

Bien entendu, il est également possible de prévoir un dispositif IMDL1$_{OR}$ comprenant un générateur apte à délivrer deux tensions continues de signes opposés et des moyens de mesure des tensions U1, U en courant continu selon le principe de la double mesure évoqué plus haut. Egalement, un dispositif IMDL1 de type "extrémité" peut comprendre des moyens de mesure de la tension U2 selon ce principe.

La figure 9 représente un autre mode de réalisation IMDL2 du dispositif de déconnexion précédemment décrit. Ici, l'idée de l'invention est d'utiliser les fils W1, W2 comme fils auxiliaires AUX1, AUX2 pour la mise en oeuvre du procédé de localisation. Ainsi, la borne Bx est supprimée. Le circuit 50 est connecté aux bornes Bw1, Bw2 par l'intermédiaire de deux interrupteurs S6, S7 et la borne Bs est connectée aux bornes Bw1, Bw2 par l'intermédiaire de deux autres interrupteurs S8, S9. Les interrupteurs S6, S7 sont ouverts et les interrupteurs S8, S9 sont fermés pendant les périodes de mesure des tensions U1, U depuis un point d'origine Po. Pendant ces périodes, le dispositif IMDL2 ne peut plus communiquer avec l'équipement de maintenance. Une temporisation est prévue pour rétablir la communication lorsque les mesures sont effectuées. La capacité 56 est de préférence une capacité électrochimique de forte valeur, permettant d'accumuler une quantité d'électricité suffisante pour maintenir les interrupteurs S8, S9 fermés pendant la temporisation.

Le dispositif IMDL2 ne différant du dispositif IMDL1 que par un agencement différent d'interrupteurs, il est clair que les premières et deuxièmes variantes décrites plus haut sont applicables à ce dispositif. Notamment, on réalise également, selon l'invention, un dispositif IMDL2$_{OR}$ du type "origine" comportant un générateur basse tension et des moyens de mesure des tensions U1, U ou de la tension U seulement.

En pratique, la combinaison de divers dispositifs IMDL1 ou IMDL2 du type "extrémité" et IMDL1$_{OR}$ ou IMDL2$_{OR}$ du type "origine" dans un réseau de câbles de télécommunication, permet d'intégrer le procédé de localisation dans un système de maintenance entièrement automatisé. Chaque dispositif IMDL1, IMDL2 est capable de déconnecter de la terre l'écran métallique d'un câble, de mesurer la résistance d'isolement de l'écran et/ou le couple électrochimique, ou de connecter l'écran aux paires de fils AUX1/AUX2 ou W1/W2 (ou au fil AUX1 ou W1 seulement, avec mesure de la tension U2). D'autre part, chaque dispositif IMDL$_{OR}$ est capable de déconnecter de la terre l'écran métallique d'un câble, de mesurer la résistance d'isolement de l'écran et/ou le couple électrochimique, d'envoyer un courant basse fréquence dans le câble, de mesurer les tensions U1 et U (ou la tension U1 seulement, avec mesure de la tension U2 par un dispositif IMDL1, IMDL2). Les mesures de résistance d'isolement sont réalisées quotidiennement, pendant quelques minutes. Les résultats des mesures, reçus par l'équipement de maintenance local, sont envoyés à un centre de maintenance régional pour traitement et analyse de l'état du réseau. Si une anomalie est détectée, le procédé de localisation selon l'invention est mis en oeuvre.

Ainsi, la présente invention permet de vérifier de façon automatique et récurrente l'état d'un câble de télécommunication ou d'un réseau de câbles, de détecter l'apparition d'un défaut d'isolement et de localiser le défaut avant que celui-ci ne s'étende aux fils téléphoniques eux-mêmes. La présente invention est par ailleurs applicable à tout type de câble, notamment aux câbles de distribution d'électricité. De façon encore plus générale, l'invention est applicable à la détection d'un défaut d'isolement entre tous types de conducteurs.

D'autre part, il ressort de ce qui précède que les termes "origine" et "extrémité" ne doivent pas être interprétés limitativement comme désignant le point d'origine et de terminaison d'un câble. De façon générale, ces termes désignent des points de connexion électrique avec un écran métallique entre lesquels le procédé de localisation selon l'invention est mis en oeuvre.

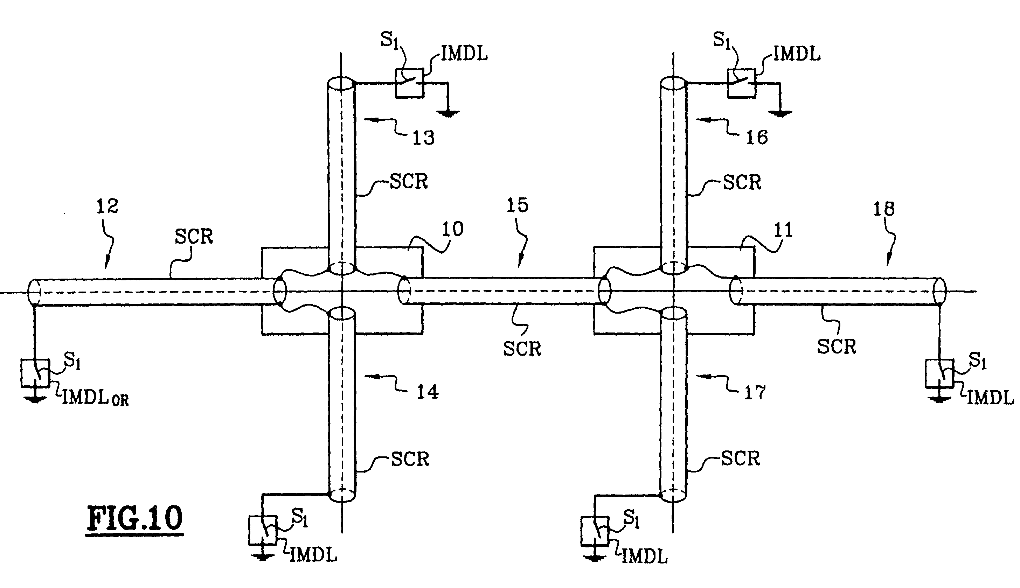

Enfin, comme représenté schématiquement sur la figure 10, l'invention permet également de localiser des défauts d'isolement apparaissant dans des boîtiers 10, 11 de raccordement de câbles 12, 13, 14, 15, 16, 17, 18, de tels boîtiers souffrant parfois de problèmes d'étanchéité. Selon une configuration de maintenance particulièrement simple représentée sur la figure 10, on agence un dispositif $IMDL_{OR}$ au point d'origine du câble 12 et des dispositifs IMDL aux points de terminaison du réseau de câbles, ici les terminaisons des câbles 13, 14, 16, 17, 18. Bien entendu, d'autres dispositifs IMDL peuvent être agencés en d'autres points du réseau de câbles, par exemple à chaque entrée et chaque sortie des boîtiers de raccordement 10, 11.

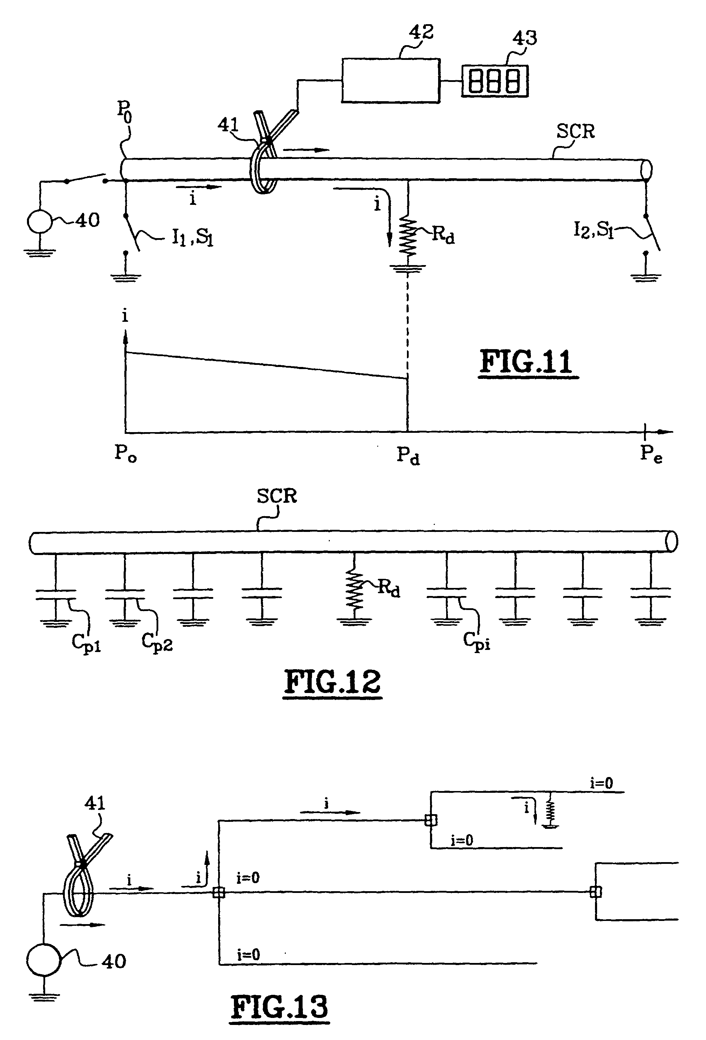

On décrira maintenant en relation avec la figure 11 un deuxième procédé de localisation selon l'invention permettant de déterminer avec une grande précision l'emplacement d'un défaut d'isolement. On suppose par exemple qu'un défaut a été localisé avec une précision de 1% sur un câble d'une longueur de 1000m au moyen du procédé décrit plus haut. Une portion de câble suspecte d'une longueur de 10m est ainsi déterminée. Après avoir déconnecté l'écran métallique SCR de la terre, on y injecte un courant alternatif i au moyen d'un générateur 40 référencé à la terre. On réalise ainsi une boucle de terre passant par la résistance Rd du défaut. Au moyen d'une pince ampèremétrique 41, en soi classique et pourvue d'un capteur sensible aux champs électromagnétiques, on observe le courant *i* circulant dans l'écran. La pince 41 est déplacée le long du câble. A l'endroit où se trouve le défaut d'isolement, le courant i est dérivé dans la terre par la résistance Rd du défaut et n'est plus détecté, comme illustré par le diagramme de la figure 11. A cet instant, on sait que le défaut d'isolement est trouvé et le câble peut être réparé.

Selon l'invention, le courant alternatif i envoyé dans l'écran SCR est un courant basse fréquence de l'ordre de 1Hz à quelques Hertz comprenant au moins deux fréquences d'oscillation, par exemple une fréquence de 1Hz et une fréquence de 10Hz. Le signal délivré par le capteur de la pince ampèremétrique 41 est envoyé à un dispositif 42, équipé d'un afficheur 43, effectuant un échantillonnage et un traitement numérique de ce signal. Ainsi, le courant i comprend au moins deux courants superposés i1, i2 de fréquences distinctes. Le traitement réalisé par le dispositif 42 consiste à analyser le signal délivré par le capteur électromagnétique, par exemple au moyen d'un algorithme de transformée de Fourrier rapide FFT, pour en extraire les deux courants *i1, i2*, puis à comparer les deux courants au fur et à mesure que l'on déplace la pince ampèremétrique le long du câble. Ce procédé permet de s'affranchir de l'influence des capacités parasites Cp1, Cp2,... $Cp_i$ réparties le long du câble, représentées sur la figure 12, formant des impédances de fuite en parallèle avec la résistance Rd pouvant atteindre des valeurs de l'ordre du Mégohm selon la fréquence du courant *i*. Ces capacités parasites $Cp_i$ répartissent le passage du courant *i* dans la terre et gênent la localisation du défaut d'isolement, notamment lorsque la résistance Rd du défaut est de forte valeur.

Plus particulièrement, la mesure des modules |*i1*|, |*i2*| des deux courants *i1, i2* permet d'établir un système de deux équations à deux inconnues à partir duquel on détermine la partie réelle *ir* des courants *i1, i2*, qui est identique pour les deux courants et ne dépend que de la résistance Rd, la résolution du système d'équations conduisant à la relation suivante :

$$(11) \qquad ir = \sqrt{((\omega_1{}^2|i_2|^2 - \omega_2{}^2|i_1|^2)/(\omega_1{}^2 - \omega_2{}^2))}$$

$\omega_1$ et $\omega_2$ étant les pulsations respectives des courants *i1, i2*.

Ainsi, la prévision d'au moins deux fréquences de travail superposées et la comparaison des deux courants *i1, i2* permet de réaliser une sorte de filtrage numérique de l'influence des capacités parasites réparties $Cp_i$ en éliminant les composantes imaginaires des deux courants qui sont fonction de ces capacités, et permet de localiser avec précision le point de défaut Rd.

Ce second procédé selon l'invention est ainsi, par nature, distinct et indépendant du procédé décrit plus haut. Il peut être mis en oeuvre indépendamment du premier procédé ou en tant que procédé complémentaire. Notamment, il est envisageable de tester un câble sur toute sa longueur au moyen de la pince ampèremétrique sans avoir préalablement localisé la portion de câble suspecte. Par exemple, comme représenté schématiquement sur la figure 13, ce second procédé permet de détecter un défaut d'isolement Rd dans un réseau arborescent de câbles, en "suivant" à proprement parler le courant de fuite i au moyen de la pince ampèremétrique 41 depuis le point d'origine du réseau, le courant i étant nul dans les branches saines du réseau.

En pratique, la déconnexion de l'écran ou des écrans d'un réseau de câbles comportant le défaut d'isolement Rd peut être faite au moyen de dispositifs IMDL de type "extrémité" ou "origine". De même, le générateur 40 référencé à la terre peut être le générateur présent dans un dispositif IMDL$_{OR}$.

**Revendications**

1. Procédé pour la localisation d'un défaut d'isolement (Rd), relativement à la terre (GND), de l'écran (SCR) d'un câble comprenant des fils conducteurs (2, AUX1, AUX2, W1, W2) l'écran étant accessible électriquement au moins en un point d'origine (Po) et en un point d'extrémité (Pe), **caractérisé en ce qu'**il comprend les étapes consistant à :

   - déconnecter l'écran (SCR) de la terre, en des points (Po, Pe) de connexion volontaire de l'écran (SCR) à la terre,
   - connecter le point d'extrémité (Pe) de l'écran à un fil conducteur auxiliaire (AUX1, W1) présent dans le câble,
   - injecter un courant entre le point d'origine (Po) et le point d'extrémité (Pe) de l'écran (SCR), au moyen d'un générateur de courant ou de tension (21) qui est isolé de la terre, en utilisant le fil conducteur auxiliaire (AUX1, W1) pour connecter le générateur de courant ou de tension (21) au point d'extrémité (Pe) de l'écran,
   - mesurer une première tension électrique (U1) au point d'origine (Po) relativement à la terre,
   - mesurer une deuxième tension électrique (U, U2) au point d'extrémité (Pe),

   la première (U1) et la deuxième (U, U2) tensions mesurées étant liées par une relation ((3), (5), (6)) représentative de la position relative (Pdr) du défaut d'isolement entre le point d'origine (Po) et le point d'extrémité (Po).

2. Procédé selon la revendication 1, dans lequel la deuxième tension (U) est mesurée relativement au point d'origine (Po), la position relative Pdr du défaut d'isolement étant donnée par la relation :

$$Pdr = U1/U$$

   ou toute autre relation équivalente, "U1" désignant la première tension mesurée et "U" la deuxième tension mesurée.

3. Procédé selon la revendication 1, dans lequel la deuxième tension (U2) est mesurée relativement à la terre, la position relative Pdr du défaut d'isolement étant donnée par la relation :

$$Pdr = U1/(U1 + U2)$$

   ou toute autre relation équivalente, "U1" désignant la première tension mesurée et "U2" la deuxième tension mesurée.

4. Procédé selon la revendication 2, comprenant les étapes suivantes :

   - connecter le point d'extrémité (Pe) de l'écran à un second fil conducteur (AUX2, W2) présent dans le câble,
   - mesurer la deuxième tension (U, U2) depuis le point d'origine (Po) de l'écran (SCR) au moyen du second fil conducteur auxiliaire (AUX2, W2) connecté au point d'extrémité (Pe) de l'écran.

5. Procédé selon l'une des revendications précédentes, dans lequel le courant injecté dans l'écran est un courant alternatif de très basse fréquence, de l'ordre du dixième de Hertz ou moins.

6. Procédé selon l'une des revendications 1 à 5, dans lequel au moins le point d'extrémité (Pe) de l'écran est déconnecté de la terre au moyen d'un dispositif de déconnexion (IMDL1, IMDL2) commandé à distance au moyen d'une paire de fils électriques (W1, W2).

7. Procédé selon la revendication 6, dans lequel un premier fil (W1) de ladite paire de fils électriques est utilisé comme premier fil conducteur auxiliaire (AUX1) pour la connexion du générateur de courant ou tension (21) au point d'extrémité (Pe) de l'écran, des moyens interrupteurs (S8) étant prévu dans le dispositif de déconnexion (IMDL2) pour connecter ledit premier fil (W1) au point d'extrémité (Pe) de l'écran (SCR).

8.  Procédé selon la revendication 7, dans lequel le second fil (W2) de ladite paire de fils électriques est utilisé comme second conducteur auxiliaire (AUX2) pour la mesure de la deuxième tension (U, U2), des moyens interrupteurs (S9) étant prévu dans le dispositif de déconnexion (IMDL2) pour connecter ledit second fil (W2) au point d'extrémité (Pe) de l'écran (SCR).

9.  Procédé. selon l'une des revendications précédentes, comprenant un procédé complémentaire de localisation du défaut d'isolement comprenant les étapes consistant à :

    -   déconnecter l'écran de la terre,
    -   injecter dans l'écran (SCR) un courant basse fréquence (i) au moyen d'un générateur (40) de courant ou de tension référencé à la terre, de manière à former une boucle de conduction passant par le défaut d'isolement (Rd) et la terre,
    -   détecter le courant circulant dans. l'écran en déplaçant le long de l'écran un dispositif (41) de détection de courant sans contact, jusqu'à détecter un point (Pd) de variation du courant dans l'écran correspondant au défaut d'isolement (Rd) recherché.

10. Procédé selon la revendication 9, dans lequel le courant (i) injecté dans l'écran (SCR) comprend au moins deux courants ($i1$, $i2$) de fréquences distinctes, et dans lequel on mesure les deux courants ($i1$, $i2$) afin de déterminer la partie réelle des deux courants indépendante de capacités parasites ($Cp_i$) réparties le long de l'écran.

11. Procédé selon l'une des revendications précédentes, dans lequel l'écran (SCR) comprend un écran métallique d'un câble de télécommunication ou plusieurs écrans métalliques de câbles de télécommunication raccordés entre eux.

12. Dispositif (IMDL1, IMDL2, IMDL1$_{OR}$, IMDL2$_{OR}$) de déconnexion relativement à la terre d'un écran métallique (SCR) d'un câble de télécommunication, comprenant des moyens (51, MP, MEM) de communication avec un équipement de maintenance par l'intermédiaire d'une paire de fils téléphoniques (W1, W2), et des moyens (60, S1, MP, MEM, COM) pour exécuter des commandes de connexion ou de déconnexion de l'écran (SCR) relativement à la terre (GND), **caractérisé en ce qu'**il comprend en outre des moyens interrupteurs (S5, S8, S9) pour connecter l'écran (SCR) à au moins un fil auxiliaire (AUX1, AUX2) présent dans le câble de télécommunication.

13. Dispositif (IMDL2) selon la revendication 12, **caractérisé en ce qu'**il comprend des moyens (S6, S7, S8, S9) pour :

    -   déconnecter les moyens de communication (50) de ladite paire de fils téléphoniques (W1, W2), et
    -   connecter l'écran (SCR) à au moins un fil de ladite paire de fils téléphoniques (W1, W2), utilisé en tant que fil auxiliaire.

14. Dispositif selon l'une des revendications 12 et 13, comprenant des moyens de mesure (63, 64, 65, MP, MEM) d'une tension électrique (U, U1, U2) présente sur l'écran métallique (SCR).

15. Dispositif (IMDL1$_{OR}$, IMDL2$_{0R}$) selon l'une des revendications 12 à 14, comprenant des moyens (21) pour injecter un courant dans l'écran métallique (SCR).

16. Système de localisation automatique d'un défaut d'isolement, vis-à-vis de la terre (GND), de l'écran métallique d'un câble comprenant des fils électriques, **caractérisé en ce qu'**il comprend :

    -   un générateur de courant ou de tension (21) agencé en un point d'origine (Po) de l'écran (SCR),
    -   des moyens de mesure (22) d'une tension électrique (U, U1, U2),
    -   des moyens (I1, I2, IMDL) pour déconnecter l'écran de la terre, en des points (Po, Pe) de connexion volontaire de l'écran (SCR) à la terre,
    -   des moyens (I3, I4, IMDL1$_{OR}$, IMDL2$_{OR}$) pour connecter le générateur (21) au point d'origine (Po) de l'écran et à un premier fil auxiliaire (AUX1, W1) présent dans le câble,
    -   des moyens (I7, I8, IMDL1$_{OR}$, IMDL2$_{OR}$) pour connecter les moyens de mesure (22) au point d'origine (Po) de l'écran et à la terre (GND), et
    -   des moyens (I5, IMDL1, IMDL2) pour connecter le fil auxiliaire (AUX1, W1) à un point d'extrémité (Pe) de l'écran.

**17.** Système selon la revendication 16, dans lequel les moyens pour connecter le premier fil auxiliaire (AUX1, W1) à un point d'extrémité (Pe) de l'écran comprennent un dispositif de déconnexion (IMDL1, IMDL2) selon l'une des revendications 14 à 17.

**18.** Système selon l'une des revendications 17 et 18, comprenant en outre des moyens (I7, I8, IMDL1$_{OR}$, IMDL2$_{OR}$) pour connecter les moyens de mesure (22) au point d'origine (Po) de l'écran et à un second fil auxiliaire (AUX2) présent dans le câble électrique, et des moyens (I6, IMDL1, IMDL2) pour connecter le second fil auxiliaire (AUX2) au point (Pe) d'extrémité de l'écran.

**Patentansprüche**

**1.** Verfahren zur Lokalisierung eines Isolationsfehlers (Rd) bei der Isolierung einer Abschirmung (CR) eines Kabels gegenüber der Erde (GND), wobei das Kabel Leitungsdrähte (2, AUX1, AUX2, W1, W2) umfasst, wobei die Abschirmung elektrisch mindestens an einem Ausgangspunkt (Po) und an einem Endpunkt (Pe) zugänglich ist, **dadurch gekennzeichnet, dass** das Verfahren folgende Schritte umfasst:

- Trennen der Abschirmung (SCR) von der Erde an Punkten (Po, Pe) freiwilliger Verbindung der Abschirmung (SCR) mit der Erde,

- Verbinden des Endpunktes (Pe) der Abschirmung mit einem Hilfsleitungsdraht (AUX1, W1), der im Kabel vorhanden ist,

- Einspeisen eines Stroms zwischen dem Ausgangspunkt (Po) und dem Endpunkt (Pe) der Abschirmung (SCR) mit Hilfe eines Strom- oder Spannungsgenerators (21), der von der Erde isoliert ist, unter Verwendung des Hilfsleitungsdrahtes (AUX1, W1), um den Stromoder Spannungsgenerator (21) am Endpunkt (Pe) der Abschirmung anzuschließen,

- Messen einer ersten elektrischen Spannung (U1) am Ausgangspunkt (Po) in Bezug zur Erde,

- Messen einer zweiten elektrischen Spannung (U, U2) am Endpunkt (Pe), wobei die erste (U1) und die zweite gemessene Spannung (U, U2) über eine repräsentative Beziehung ((3), (5), (6)) der relativen Position (Pdr) des Isolationsfehlers zwischen dem Ausgangspunkt (Po) und dem Endpunkt (Pe) verbunden sind.

**2.** Verfahren nach Anspruch 1, bei dem die zweite Spannung (U) relativ zum Ausgangspunkt gemessen wird, wobei die relative Position Pdr des Isolationsfehlers durch die Beziehung

$$Pdr = U1/U$$

oder jede andere, gleichwertige Beziehung gegeben ist, wobei "U1" die erste gemessene Spannung und "U" die zweite gemessene Spannung bezeichnet.

**3.** Verfahren nach Anspruch 1, bei dem die zweite Spannung (U2) relativ zur Erde gemessen wird, wobei die relative Position Pdr des Isolationsfehlers durch die Beziehung

$$Pdr = U1/(U1 + U2)$$

oder jede andere, gleichwertige Beziehung gegeben ist, wobei "U1" die erste gemessene Spannung und "U2" die zweite gemessene Spannung bezeichnet.

**4.** Verfahren nach Anspruch 2, welches folgende Schritte umfasst:

- Verbinden des Endpunktes (Pe) der Abschirmung mit einem zweiten Leitungsdraht (AUX2, W2), der im Kabel vorhanden ist,

- Messen der zweiten Spannung (U, U2) vom Ausgangspunkt (Po) der Abschirmung (SCR) aus mit Hilfe des zweiten Hilfsleitungsdrahtes (AUX2; W2), der an den Endpunkt (Pe) der Abschirmung angeschlossen ist.

5. Verfahren nach einem der vorhergehenden Ansprüche, bei dem der in die Abschirmung eingespeiste Strom ein Wechselstrom mit sehr niedriger Frequenz in der Größenordnung von Zehntelhertz oder weniger ist.

6. Verfahren nach einem der Ansprüche 1 bis 5, bei dem mindestens der Endpunkt (Pe) der Abschirmung von der Erde mit Hilfe einer Trennvorrichtung (IMDL1, IMDL2) getrennt ist, welche mit Hilfe eines Paars elektrischer Drähte (W1, W2) ferngesteuert ist.

7. Verfahren nach Anspruch 6, bei dem ein erster Draht (W1) des Paars elektrischer Drähte als erster Hilfsleitungsdraht (AUX1) für die Verbindung des Strom- oder Spannungsgenerators (21) mit dem Endpunkt (Pe) der Abschirmung verwendet wird, wobei Unterbrechungsmittel (S8) in der Trennvorrichtung (IMDL2) vorgesehen sind, um den ersten Draht (W1) am Endpunkt (Pe) der Abschirmung (SCR) anzuschließen.

8. Verfahren nach Anspruch 7, bei dem der zweite Draht (W2) des Paars elektrischer Drähte als zweiter Hilfsleitungsdraht (AUX2) für das Messen der zweiten Spannung (U, U2) verwendet wird, wobei Unterbrechungsmittel (S9) in der Trennvorrichtung (IMDL2) vorgesehen sind, um den zweiten Draht (W2) an den Endpunkt (Pe) der Abschirmung (SCR) anzuschließen.

9. Verfahren nach einem der vorhergehenden Ansprüche, wobei das Verfahren ein ergänzendes Verfahren zur Lokalisierung des Isolationsfehlers aufweist, welches folgende Schritte umfasst:

   - Trennen der Abschirmung von der Erde,

   - Einspeisen eines Niederfrequenzstroms (i) in die Abschirmung (SCR) mit Hilfe eines Strom- oder Spannungsgenerators (40), der mit der Erde verbunden ist, so dass eine Leitungsschleife gebildet wird, welche über den Isolationsfehler (Rd) und die Erde verläuft,

   - Erfassen des Stroms, der in der Abschirmung fließt, indem entlang der Abschirmung eine Vorrichtung (41) zum kontaktfreien Erfassen des Stroms verschoben wird, bis ein Punkt (Pd) der Schwankung des Stroms in der Abschirmung erfasst wird, welcher dem gesuchten Isolationsfehler (Rd) entspricht.

10. Verfahren nach Anspruch 9, bei dem der in die Abschirmung (SCR) eingespeiste Strom (i) mindestens zwei Stromflüsse (i1, i2) mit unterschiedlichen Frequenzen umfasst und bei dem die zwei Stromflüsse (i1, i2) gemessen werden, um den Realteil der zwei Stromflüsse zu bestimmen, unabhängig von den parasitären Kapazitäten ($Cp_i$), die entlang der Abschirmung verteilt sind.

11. Verfahren nach einem der vorhergehenden Ansprüche, bei dem die Abschirmung (SCR) eine Metallabschirmung eines Telekommunikationskabels oder mehrere Metallabschirmungen von Telekommunikationskabeln umfasst, die untereinander verbunden sind.

12. Vorrichtung (IMDL1, IMDL2, $IMDL1_{OR}$, $IMDL2_{OR}$) zum Trennen einer Metallabschirmung (SCR) eines Telekommunikationskabels bezüglich der Erde, wobei die Vorrichtung Mittel (51, MP, MEM) zur Kommunikation mit einer Wartungsausrüstung über ein Paar Telefondrähte (W1, W2) und Mittel (60, S1, MP, MEM, COM) umfasst, um Befehle zum Verbinden oder Trennen der Abschirmung (SCR) bezüglich der Erde (GND) auszuführen, **dadurch gekennzeichnet, dass** die Vorrichtung außerdem Unterbrechungsmittel (S5, S8, S9) umfasst, um die Abschirmung (SCR) an mindestens einen Hilfsdraht (AUX1, AUX2) anzuschließen, der im Telekommunikationskabel vorhanden ist.

13. Vorrichtung (IMDL2) gemäß Anspruch 12, **dadurch gekennzeichnet, dass** die Vorrichtung Mittel (S6, S7, S8, S9) umfasst, um:

   - die Kommunikationsmittel (50) von dem Paar von Telefondrähten (W1, W2) zu trennen, und

   - die Abschirmung (SCR) an mindestens einen Draht des Paars Telefondrähte (W1, W2) anzuschließen, der als Hilfsdraht verwendet wird.

14. Vorrichtung nach einem der Ansprüche 12 oder 13, welche Mittel zum Messen (63, 64, 65, MP, MEM) einer elektrischen Spannung (U, U1, U2) umfasst, die auf der Metallabschirmung (SCR) vorhanden ist.

15. Vorrichtung (IMDLI$_{OR}$, IMDL2$_{OR}$) nach einem der Ansprüche 12 bis 14, welche Mittel (21) umfasst, um einen Strom in die Metallabschirmung (SCR) einzuspeisen.

16. System zur automatischen Lokalisierung eines Isolationsfehlers der Metallabschirmung eines Kabels gegenüber der Erde (GND), wobei das Kabel elektrische Drähte umfasst, **dadurch gekennzeichnet, dass** das System umfasst:

   - einen Strom- oder Spannungsgenerator (21), der an einem Ausgangspunkt (Po) der Abschirmung (SCR) angeordnet ist,

   - Mittel zum Messen (22) einer elektrischen Spannung (U, U1, U2),

   - Mittel (I1, I2, IMDL) zum Trennen der Abschirmung von der Erde an Punkten (Po, Pe) freiwilliger Verbindung der Abschirmung (SCR) mit der Erde,

   - Mittel (I3, I4, IMDL1$_{OR}$, IMDL2$_{OR}$) zum Anschließen des Generators (21) an den Ausgangspunkt (Po) der Abschirmung und an einen ersten Hilfsdraht (AUX1, W1), der im Kabel vorhanden ist,

   - Mittel (17, I8, IMDL1$_{OR}$, IMDL2$_{OR}$), um die Mittel zum Messen (22) an den Ausgangspunkt (Po) der Abschirmung und an die Erde (GND) anzuschließen, und

   - Mittel (I5, IMDL1, IMDL2), um den Hilfsdraht (AUX1, W1) an einen Endpunkt (Pe) der Abschirmung anzuschließen.

17. System nach Anspruch 16, bei dem die Mittel zum Anschließen des ersten Hilfsdrahts (AUX1, W1) an einen Endpunkt (Pe) der Abschirmung eine Trennvorrichtung (IMDL1, IMDL2) nach einem der Ansprüche 14 bis 17 umfassen.

18. System nach einem der Ansprüche 17 oder 18, welches außerdem Mittel (I7, I8, IMDL1$_{OR}$, IMDL2$_{OR}$), um die Mittel zum Messen (22) an den Ausgangspunkt (Po) der Abschirmung und an einen zweiten Hilfsdraht (AUX2) anzuschließen, der im elektrischen Kabel vorhanden ist, und Mittel (I6, IMDL1, IMDL2) umfasst, um den zweiten Hilfsdraht (AUX2) am Endpunkt (Pe) der Abschirmung anzuschließen.

**Claims**

1. Method of locating an earth (GND) insulation fault (Rd) in a cable screen (SCR) comprising conductor wires (2, AUX1, AUX2, W1, W2), the screen being electrically accessible at least at a source (Po) and at an end point (Pd), **characterised in that** it comprises steps consisting of :

   - disconnecting the screen (SCR) from earth, at points of voluntary connection (Po, Pe) from the screen (SCR) to earth,
   - connecting the end point (Pe) of the screen to an auxiliary conductor wire (AUX1, W1) in the cable,
   - injecting a current between the source (Po) and the end point (Pe) of the screen (SCR) by means of a current or voltage generator (21) which is earth insulated, while using the auxiliary conductor wire (AUX1, W1) to connect the current or voltage generator (21) to the end point (Pe) of the screen,
   - measuring a first electric voltage (U1) at the earth source (Po),
   - measuring a second electric voltage (U, U2) at the end point (Pe), the first (U1) and second (U, U2) measured voltages being linked by a relation ((3), (5), (6)) representative of the relative position (Pdr) of the insulation fault between the source (Po) and the end point (Pe).

2. Method according to claim 1, in which the second voltage (U) is measured relating to the source (Po), the relative position Pdr of the insulation fault being given as the relation :

$$Pdr = U1/U$$

or any other equivalent relation, "U1" representing the first measured voltage and "U" the second measured voltage.

3.   Method according to claim 1, in which the second voltage (U2) is measured, relating to earth, the relative position Pdr of the insulation fault being given as the relation :

$$Pdr = U1/(U1 + U2)$$

or any other equivalent relation, "U1" representing the first measured voltage and "U2" the second measured voltage.

4.   Method according to claim 2, comprising the following steps :

-   connecting the end point (Pe) of the screen to a second conductor wire (AUX2, W2) in the cable,
-   measuring the second voltage (U, U2) from the source (Po) of the screen (SCR) by means of the second auxiliary conductor wire (AUX2, W2) connected to the end point (Pe) of the screen.

5.   Method according to one of the preceding claims, in which the current injected into the screen is an alternating current of very low frequency, in the order of ten Hertz or less.

6.   Method according to one of claims 1 to 5, in which at least the end point (Pe) of the screen is disconnected from earth by means of a disconnecting device (IMDL1, IMDL2) remote controlled by means of a pair of electric wires (W1, W2).

7.   Method according to claim 6, in which a first wire (W1) of the said pair of electric wires is used as a first auxiliary conductor wire (AUX1) for connecting the current or voltage generator (21) to the end point (Pe) of the screen, switching means (58) being provided in the disconnecting device (IMDL2) to connect the first wire (W1) to the end point (Pe) of the screen.

8.   Method according to claim 7, in which the second wire (W2) of the said pair of electric wires is used as a second auxiliary conductor wire (AUX2) for measuring the second voltage (U, U2), switching means (S9) being provided in the disconnecting device (IMDL2) for connecting the said second wire (W2) to the end point (Pe) of the screen (SCR).

9.   Method according to one of the preceding claims, comprising an additional method for locating an insulation fault which includes steps consisting of :

-   disconnecting the screen from earth,
-   injecting into the screen (SCR) a low frequency current (i) by means of a current or voltage generator (40) relating to earth, in such a way as to form a conduction loop passing through the insulation fault (Rd) and earth,
-   detecting the current circulating in the screen by placing a device (41) along the screen for detecting a non-contact current until a point (Pd) is detected where there is a variation in the current in the screen corresponding to the sought after insulation fault (Rd).

10.  Method according to claim 9, in which the current (i) injected into the screen (SCR) comprises two currents (i1, i2) of distinct frequencies, and in which the two currents (i1, i2) are measured to determine the real part of the two currents which is independent of the parasitic capacitances (Cp$_i$) distributed along the screen.

11.  Method according to one of the preceding claims, in which the screen (SCR) comprises a metal screen for a telecommunications cable or several metal screens for interconnecting telecommunications cables.

12.  Device (IMDL1, IMDL2, IMDL1$_{OR}$, IMDL2 $_{OR}$) for disconnecting, from earth, a metal screen (SCR) for a telecommunications cable, comprising means (51, MP, MEM) for communicating with maintenance apparatus by means of a pair of telephone wires (W1, W2) and means (60, S1, MP, MEM, COM) for carrying out commands to connect or disconnect the screen (SCR) from earth (GND), **characterised in that** it also comprises switching means (S5, S8, S9) for connecting the screen (SCR) to at least one auxiliary wire (AUX1, AUX2) in the telecommunications cable.

**13.** Device (IMDL2) according to claim 12, **characterised in that** it comprises means (S6, S7, S8, S9) for :

- disconnecting the communication means (50) from the said pair of telephone wires (W1, W2), and
- connecting the screen (SCR) to at least one wire, from the said pair of telephone wires (W1, W2), used as an auxiliary wire.

**14.** Device according to one of claims 12 and 13, comprising means (63, 64, 65, MP, MEM) for measuring an electric voltage (U, U1, U2) in the metal screen (SCR).

**15.** Device ($IMDL1_{OR}$, $IMDL2_{OR}$) according to one of claims 12 to 14, comprising means (21) for injecting a current into the metal screen (SCR).

**16.** System for automatically locating an earth (GND) insulation fault in a metal cable screen comprising electric wires, **characterised in that** it comprises :

- a current or voltage generator (21) used at a source (Po) in the screen (SCR),
- means (22) for measuring an electric voltage (U, U1, U2),
- means (I1, 12, IMDL) for disconnecting the screen from earth, at points (Po, Pe) of voluntary connection from the screen (SCR) to earth,
- means (13, 14, $IMDL1_{OR}$, $IMDL2_{OR}$) for connecting the generator (21) to the source (Po) of the screen and to a first auxiliary wire (AUX1, W1) in the cable,
- means (17, 18, $IMDL1_{OR}$, $IMDL2_{OR}$) for connecting the measuring means (22) to the source (Po) of the screen and to earth (GND), and
- means (15, IMDL1, IMDL2) for connecting the auxiliary wire (AUX1 W1) to an end point (Pe) of the screen.

**17.** System according to claim 16, in which the means for connecting the first auxiliary wire (AUX2, W1) to an end point (Pe) of the screen comprise a disconnecting device (IMDL1, IMDL2) according to one of claims 14 to 17.

**18.** System according to one of claims 17 or 18, in addition comprising means (17, 18, $IMDL1_{OR}$, $IMDL2_{OR}$) for connecting the measuring means (22) to the source (Po) of the screen and to a second auxiliary wire (AUX2) in the electric cable, and means (16, INDL1, IMDL2) for connecting the second auxiliary wire (AUX2) to the end point (Pe) of the screen.

FIG.1A

FIG.1B

FIG.2

FIG.3

**FIG.4**

**FIG.5**

**FIG.6**

$$\underline{\text{FIG.7}}$$

**FIG.8**

IMDL1

**FIG.9**

IMDL2

**FIG.10**

**FIG.11**

**FIG.12**

**FIG.13**